# EUROPEAN PATENT SPECIFICATION

(11) **EP 0 532 616 B1**
(45) Date of publication and mention of the grant of the patent: **04.01.1995**
(21) Application number: 91911050.2
(22) Date of filing: 31.05.1991
(51) Int. Cl.: G01R 31/11, G01M 3/18

(54) **ELECTRONIC CIRCUITRY FOR DETECTING LEAKAGE OF CHEMICAL SUBSTANCE**
ELEKTRONISCHE SCHALTUNG ZUR DETEKTION VON LECKAGE CHEMISCHER SUBSTANZEN
CIRCUIT ELECTRONIQUE SERVANT A DETECTER LES FUITES DE SUBSTANCES CHIMIQUES

(30) Priority: 04.06.1990 US 533250
(43) Date of publication of application: 24.03.1993
(73) Proprietor: W.L. GORE & ASSOCIATES, INC., Newark, Delaware 19714-9206 (US)
(72) Inventor: REDDY, William, John, Scottsdate, AZ 85254 (US); BERKMAN, Samuel, Sun Lakes, AZ 85248 (US)
(74) Representative: Klunker . Schmitt-Nilson . Hirsch
(86) International application number: US9103855
(87) International publication number: WO9119206

(56) References cited:
- FR-A- 2 287 646
- US-A- 4 877 923
- PATENT ABSTRACTS OF JAPAN, Vol. 7, No. 113 (P-197)(1258), May 18, 1983; & JP-A-58 33 145
- WIRELESS WORLD, vol. 89, no. 1571, August 1, 1983, Sheepen, Place, Olchester, GB, page 39: "direct reading cable reflectometer"
- IBM TECHN. DISCL. BULL., Vol. 17, No. 10, March 1975, pages 3078-3079, Elliot: "Sensitive time domain reflectometer for observing multiple reflections"

## Description

This invention relates to electrical leak detection circuitry and especially to circuitry designed to detect leaks of liquid chemicals, such as hydrocarbons, from piping or storage tanks.

Leakage of liquid hydrocarbons can be detected electronically by placing an electric detection cable along hydrocarbon storage tanks or along piping for carrying the hydrocarbon. Such cables are well known, as seen, for example, in U.S. Pat. Nos. 4,877,923 (Sahakian) and 4,029,889 (Mizuochi). In such cables, the leaking liquid penetrates insulation between conductor wires causing the electrical characteristics of the cable to change. Usually, time domain reflectometry (TDR) procedures are used to detect these changes.

TDR techniques are known in the art. For example, J. Suter, "Direct Reading Cable Reflectometer," *Wireless World*, vol. 89, no. 1571, August 1983, p. 39, shows a circuit which uses the principles of TDR to determine the length of a cable.

In TDR procedures, an electrical impulse is sent down the conductor wires and the impedance is monitored. Any change in the impedance caused by, for example, a break in the cable or a change in the dielectric of the insulation is recorded as a reflected wave of the pulse.

A difficulty arises with TDR in that TDR equipment inherently records a rise in impedance as the length of the cable increases. Thus, when sensitivity limits are set against a voltage zero standard, the apparent rise in impedance means that near the far end of the cable, the sensitivity limit will be much wider than the original limit. This means that leaks near the far end of the cable could go undetected if the magnitude of the reflected wave does not encompass or exceed the wider threshold limit. It is a purpose of this invention to overcome this difficulty and to provide a simple circuit which may be used for leak detection.

Patent Abstract of Japan, vol. 7, no. 113 (P-197)(1258), May 18, 1983, (abstract of Japanese Pat. Document No. 58-33145), discloses a method for measuring the width of a leak (i.e., the length of a leak detection cable which has been permeated by a leaking liquid) using a TDR technique. A pulse is transmitted down the cable and a sample and hold circuit and an analog-to-digital converter (under control of a controller) are used to sample the cable for reflections from the end of the cable. The propagation time of a pulse reflected from the distant end of the cable is computed. A leaking liquid which permeates the cable will cause the propagation time to change and may be used to indicate a leak. The difference in the propagation times may be used to compute the width of the leak. This type of circuit provides an alternate way of monitoring a cable for leaks.

### SUMMARY OF THE INVENTION

The apparent rise of impedance over distance in TDR circuitry is eliminated in the invention herein by:
1) reducing the TDR to a single launch pulse and monitoring the effects of the single pulse so that no pulse overlap occurs;
2) by providing a time delay component that resets the trip latches when they are tripped by the strength of the launch pulse so that only reflections are monitored after the latches are reset;
3) by providing a digital-to-analog converter programmed to set the upper sensitivity limit against voltage zero and programmed to adjust the lower threshold sensitivity to the most negative voltage dip created by imperfections in the cable.

The rise in impedance is eliminated at the far end, enabling good sensitivity to be achieved.

### BRIEF DESCRIPTION OF THE DRAWINGS

Figure 1 is a schematic diagram of the circuitry of the system of the invention.

Figure 2 depicts a voltage zero line and upper and lower voltage threshold levels.

### DESCRIPTION OF THE INVENTION

In this invention, time domain reflectometry (TDR) techniques are used to monitor a leak detection cable, such as coaxial cable. TDR is used to sense changes in the impedance of the cable. "Impedance", as used herein, is the electrical resistance to a signal being transmitted down the cable. Maximum signal transfer is attained when the impedance of the cable is uniformly distributed so that no reflections occur.

A terminated cable is used since a matched resistive load placed across the open end of the cable makes the cable appear to be infinitely long. A properly terminated cable will have no reflections of the pulse.

However, once the cable is broken or the impedance changed due to a leak that changes the dielectric of the insulation, a "cable fault" has been created at that point. This creates an impedance mismatch. It is this mismatch that causes a reflected wave return of the original pulse, and this phenomena is known as "reflectance". Not only can an impedance mismatch occur from a break or a change of the insulation dielectric, but it can also occur from faults inherent in the cable, such as a connector in the line or a kink in the line. It is desirable to eliminate or minimize such inherent imperfections in order to set the sensitivity limit as close to an actual break or leak as possible. This becomes particularly important as the cable length increases since attenuation or power strength loss increases as the cable length increases. Thus, the smaller impedance change recorded near the far end of the detection cable can be recorded by the circuitry of this invention.

The "reflectance" can be of two types. It can be what is called a "positive reflectance" in which the amplitude of the reflected pulse is above the system ground and is due to a low to high impedance transition (which means it is caused by an open or connector mismatch). The reflectance can also be a "negative reflectance" in which the amplitude of the reflected.pulse is below the system ground and is due to a high to low impedance transition (which means it is due to a short or leak).

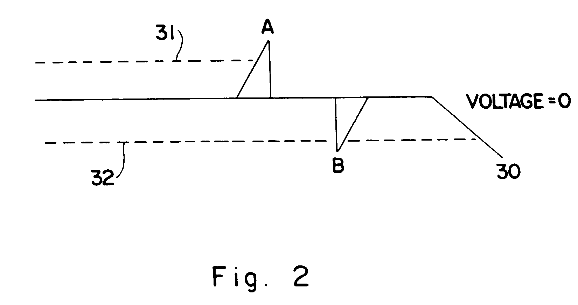

As shown in Figure 2, the black horizontal line 30 represents a voltage zero line of an oscilloscope. The dotted lines 31 and 32 denote the upper and lower voltage threshold respectively and taken together show typical sensitivity limits. A positive reflection is denoted by Peak "A" and a negative reflection is denoted by Peak "B".

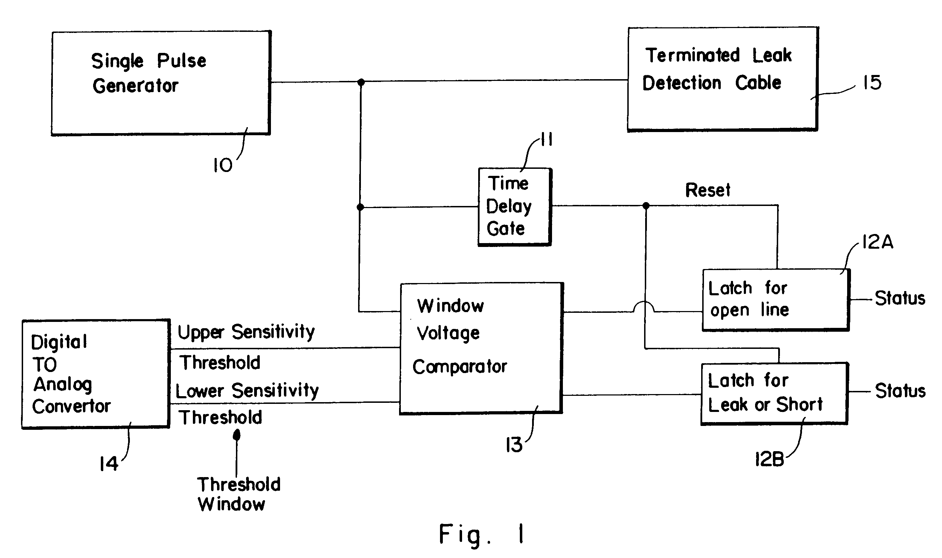

Referring now to Figure 1, the leak detection circuitry comprises a pulse generator 10, time delay gate 11, two RS latches 12A and 12B (one for a positive reflection and one for a negative reflection), a high speed window comparator 13 and a digital-to-analog converter 14 (DAC).

The pulse generator, of course, generates the single pulse and sends it down the terminated leak detection cable, which, in Figure 1, is denoted by 15. Use of a single pulse is important because it precludes pulse overlapping which results in impedance rise at the furthest end of the cable.

The time delay gate 11 is used to reset the trip latches when they are tripped by the intensity of the launch pulse so that only reflections are monitored.

The status outputs of the RS latches 12A and 12B record the effects that the launch pulse has on the cable due to impedance mismatches and their resulting reflections.

The high speed signal comparator 13 is an electronic device that compares the pulse pattern with the sensitivity limits. If the dip in the pulse reflectance exceeds the sensitivity limit, the latch is tripped and an appropriate warning is indicated.

The digital-to-analog converter is used to set the upper sensitivity limit and is used to electronically adjust the lower threshold at a variable level that, for a particular cable, will be just off the level of the most negative voltage dip caused by cable imperfections.

It is convenient to employ a microprocessor chip to continually process the data and automatically monitor and control the various functions. The microprocessor initiates the sequence of events and monitors the results. It also controls the operation of the digital-to-analog converter which in turn establishes and records the upper and lower sensitivity thresholds.

The sequence of events to test a terminated cable for faults or leaks is as follows:

A single pulse is launched at one end of the cable. Since the connector and latches must be located near the launch point in order to detect reflections along substantially all the cable line, the latches are tripped immediately upon launching of the pulse. In order to reset the latches so that they can then sense reflections of a predetermined magnitude, a portion of the launch pulse is tapped off, delayed a specific amount of time (long enough for the launch pulse to be on its way down the cable), and applied to the reset inputs of the latches. This results in self-resetting circuitry that resets the latches. There are two RS latches, one to capture positive reflections, the other to capture negative reflections. If no reflections occur on a properly terminated cable, the latches will not be set and the cable is considered undisturbed. If any of the latches are set, then a fault has occurred and been detected in the cable. The type of fault can then be determined by distinguishing which latch has been set.

The sensitivity of the latches to reflections is established by adjusting the comparator's voltage "window". The microcontroller and the DAC are used for this to obtain an auto-referencing circuit. Referencing is initiated by pressing a momentary switch. Since the upper (positive) voltage of the comparator window only detects a cable open, it is set to a stationary value. However, the lower (negative) voltage of the comparator window determines how sensitive the comparator is to sensing leaks (or shorts) and will vary from cable to cable. Upon referencing, the DAC initially sets up the comparator with a wide window and a pulse is sent down the cable. If the latches remain cleared (no faults), then the lower (negative) window is closed one DAC step and again a pulse is sent and the latches read. This process is repeated until at some point the latch representing a leak becomes set. This occurs at the greatest reflection point found on the cable. This could be from a connector or just the steady state noise level of the cable. The DAC then opens the window slightly and the circuit is ready to detect leaks.

## Claims

1. An electrical circuit for detecting leakage of a liquid including a leak detection cable (15) which is terminated by a resistive load and which cable changes impedance when penetrated by the liquid, said electrical circuit comprising:
- electrical pulse generator means (10) for generating a single electrical launch pulse, and for transmitting said single electrical launch pulse down the leak detection cable (15); **characterized by**
- said resistive load being a matched resistive load;
- sensing means (13), electrically connected to the leak detection cable (15), for producing a trip signal upon receiving, from the leak detection cable, a reflected launch pulse which exceeds a predetermined threshold;
- delay means (11), responsive to said single electrical launch pulse, for producing a reset signal upon the transmission of said single electrical launch pulse,
- first and second latch means (12A; 12B), connected to said sensing means (13), for latching upon receiving said trip signal, and for unlatching upon receiving said reset signal, wherein said latching of said second latch means (12B) is indicative of a detection of the leakage of the liquid, and
- a digital-to-analog converter programmed to set an upper sensivity threshold and a lower sensivity threshold of said latch means (12A; 12B), each defined by a certain voltage value.

2. The electrical circuit of claim 1, further comprising:
- a microcontroller unit including,
1) for causing said electrical pulse generator means (10) to generate said single electrical launch pulse,
2) means (14) for determining said pre-determined threshold, and
3) means for generating first and second fault status signals in response to a latching state of said first and second latch means respectively (12A, 12B), wherein said fault status signal indicates the leakage.

3. The electrical circuit of claim 2, wherein:
- said digital-to-analog converter receives said predetermined thresholds from said microcontroller unit, for converting each of said predetermined thresholds from a digital signal to an analog signal, and for supplying said signal to said sensing means (13).

4. The electrical circuit of claim 3, wherein said sensing means comprises:
a first voltage comparator (13), adapted, to produce a first trip signal when said reflected launch pulse exceeds a positive threshold, said first trip signal being indicative of an open in the leak detection cable, and
a second voltage comparator (13) adapted, to produce a second trip signal when said reflected launch pulse exceeds a negative threshold, said second trip signal being indicative of the leakage of the liquid.

5. The electrical circuit of claim 4, wherein said latch means comprises:
a first latch (12A) responsive to said first trip signal, and
a second latch (12B) response to said second trip signal.

6. A method for monitoring an impedance of a leak detection cable terminated by a matched resistive load, wherein a fault signal is generated in response to a change in the impedance of the cable, the method comprising the steps of:
(a) selecting a reflexion detection threshold for the leak detection cable by using a digital-to-analog convertor;
(b) generating a single electrical launch pulse;
(c) transmitting said launch pulse down the leak detection cable (15);
(d) tapping off and delaying a portion of said launch pulse to generate a reset signal;
(e) resetting a latch (12A, 12B) in response to said reset signal;
(f) monitoring the leak detection cable (15) for a reflected launch pulse;
(g) comparing said reflected launch pulse to said reflection detection threshold;
(h) generating a trip signal when said reflected launch pulse exceeds said reflection detection threshold; and
(i) setting said latch (12A, 12B) and generating a fault signal in response to said trip signal.

7. The method of claim 6, further comprising a step of autoreferencing the leak detection cable to refine said reflection threshold, said step of autoreferencing including the steps of
(1) setting said reflection detection threshold to a predetermined value;
(2) performing steps (b) through (i);
(3) monitoring said latch for generation of said fault signal;
(4) if said fault signal is not detected, then increasing the value of said reflection detection threshold by a predetermined amount and repeating steps (2) - (4) until said fault signal is detected; and
(5) if said fault signal is detected, then decreasing the value of said reflection detection threshold by a predetermined amount.

## Patentansprüche

1. Elektrische Schaltung zum Detektieren einer Flüssigkeitsleckage, mit einem Leckdetektorkabel (15), welches von einer Widerstandslast abgeschlossen ist, und welches seine Impedanz ändert, wenn Flüssigkeit in das Kabel eindringt, wobei die Schaltung umfaßt:
- eine elektrische Impulsgeneratoreinrichtung (10) zum Erzeugen eines einzelnen elektrischen Startimpulses und zum Senden des einzelnen elektrischen Startimpulses in das Leckdetektorkabel (15);
**dadurch gekennzeichnet**, daß
- die Widerstandslast eine angepaßte Widerstandslast ist;
- eine Fühleinrichtung (13) elektrisch mit dem Leckdetektorkabel (15) verbunden ist, um bei Empfang eines einen vorbestimmten Schwellenwert überschreitenden, reflektierten Startimpulses aus dem Leckdetektorkabel ein Auslösesignal zu erzeugen;
- eine Verzögerungseinrichtung (11) auf den einzelnen elektrischen Startimpuls anspricht, um bei Senden des einzelnen elektrischen Startimpulses ein Rücksetzsignal zu erzeugen,
- eine erste und eine zweite Rasteinrichtung (12A; 12B) mit der Fühleinrichtung (13) verbunden sind, um bei Empfang des Auslösesignals einzurasten und bei Empfang des Rücksetzsignals auszurasten, wobei das Einrasten der zweiten Rasteinrichtung (12B) kennzeichnend für das Detektieren der Flüssigkeitsleckage ist, und
- einen Digital-Analog-Wandler, welcher so programmiert ist, daß ein oberer Empfindlichkeits-Schwellenwert und ein unterer Empfindlichkeits-Schwellenwert der Rasteinrichtung (12A; 12B) eingestellt werden, jeweils definiert durch einen gewissen Spannungswert.

2. Elektrische Schaltung nach Anspruch 1, umfassend:
- eine Mikrosteuerungseinheit mit
1) einer Einrichtung, welche die elektrische Impulsgeneratoreinrichtung (10) veranlaßt, den einzelnen elektrischen Startimpuls zu erzeugen,
2) einer Einrichtung (14) zum Festlegen des vorbestimmten Schwellenwertes, und
3) eine Einrichtung zum Erzeugen eines ersten und eines zweiten Fehlerstatussignals in Abhängigkeit eines Einrastzustands der ersten bzw. der zweiten Rasteinrichtung (12A, 12B), wobei das Fehlerstatussignal die Leckage anzeigt.

3. Elektrische Schaltung nach Anspruch 2, bei der
- der Digital-Analog-Wandler die vorbestimmten Schwellenwerte von der Mikrosteuerungseinheit empfängt, um jeden der vorbestimmten Schwellenwerte aus einem digitalen Signal in ein Analogsignal umzusetzen, und um das Signal der Fühleinrichtung (13) zuzuführen.

4. Elektrische Schaltung nach Anspruch 3, bei der die Fühleinrichtung aufweist:
einen ersten Spannungsvergleicher (13), der dazu dient, ein erstes Auslösesignal zu erzeugen, wenn der reflektierte Startimpuls einen positiven Schwellenwert übersteigt, wobei das erste Auslösesignal kennzeichnend für eine offene Stelle in dem Leckdetektorkabel ist, und
einen zweiten Spannungsvergleicher (13), der dazu dient, ein zweites Auslösesignal zu erzeugen, wenn der reflektierte Startimpuls einen negativen Schwellenwert überschreitet, wobei das zweite Auslösesignal kennzeichnend für die Flüssigkeitsleckage ist.

5. Elektrische Schaltung nach Anspruch 4, bei der die Rasteinrichtung aufweist:
ein erstes Rastelement (12A), welches auf das erste Auslösesignal anspricht, und
ein zweites Rastelement (12B), das auf das zweite Auslösesignal anspricht.

6. Verfahren zum Überwachen einer Impedanz eines mit einem angepaßten Lastwiderstand abgeschlossenen Leckdetektorkabels, bei dem ein Fehlersignal ansprechend auf eine Änderung der Kabelimpedanz erzeugt wird, umfassend die Schritte:
(a) Auswählen eines Reflexions-Detektorschwellenwertes für das Leckdetektorkabel unter Verwendung eines Digital-Analog-Wandlers;
(b) Erzeugen eines einzelnen elektrischen Startimpulses;
(c) Senden des Startimpulses in das Leckdetektorkabel (15);
(d) Anzapfen und Verzögern eines Teil des Startimpulses, um ein Rücksetzsignal zu erzeugen;
(e) Rücksetzen eines Rastelementes (12A, 12B) ansprechend auf das Rücksetzsignal;
(f) Überwachen des Leckdetektorkabels (15) bezüglich eines reflektierten Startimpulses;
(g) Vergleichen des reflektierten Startimpulses mit dem Reflexions-Detektorschwellenwert;
(h) Erzeugen eines Auslösesignals, wenn der reflektierte Startimpuls den Reflexions-Schwellenwert überschreitet; und
(i) Setzen des Rastelementes (12A, 12B) und Erzeugen eines Fehlersignals in Abhängigkeit des Auslösesignals.

7. Verfahren nach Anspruch 6,
**gekennzeichnet durch**
einen Schritt der Eigen-Bezugswertbildung des Leckdetektorkabels, um den Reflexionsschwellenwert zu verfeinern, wobei der Schritt der Eigen-Bezugswertbildung die Schritte aufweist:
(1) Einstellen des Reflexions-Detektorschwellenwerts auf einen vorbestimmten Wert;
(2) Durchführen der Schritte (b) bis (i);
(3) Überwachen des Rastelementes bezüglich der Erzeugung des Fehlersignales;
(4) falls das Fehlersignal nicht erfaßt wird, anschließendes Erhöhen des Werts des Reflexions-Detektorschwellenwerts um einen vorbestimmten Betrag, und Wiederholen der Schritte (2) - (4), bis das Fehlersignal festgestellt wird; und
(5) falls das Fehlersignal festgestellt wird, anschließendes Verringern des Reflexions-Detektorschwellenwerts um einen vorbestimmten Betrag.

## Revendications

1. Circuit électrique pour détecter des fuites d'un liquide comprenant un câble de détection de fuites (15) qui est refermé par une charge résistive, lequel câble change d'impédance lorsqu'il est imprégné par le liquide, ledit circuit électrique comprenant :
un moyen générateur d'impulsion électrique (10) pour produire une unique impulsion électrique d'envoi, et pour émettre ladite unique impulsion électrique d'envoi dans le câble de détection de fuites (15) ; caractérisé par :
le fait que ladite charge résistive est une charge résistive adaptée ;
un moyen de détection (13) connecté électriquement au câble de détection de fuites (15), pour produire un signal de déclenchement lors de la réception, en provenance du câble de détection de fuites, d'une impulsion d'envoi réfléchie qui dépasse un seuil prédéterminé ;
un moyen de retardement (11), sensible à ladite unique impulsion électrique d'envoi, pour produire un signal de remise à zéro lors de l'émission de ladite unique impulsion électrique d'envoi ;
des premier et second moyens de bascule (12A ; 12B), connectés audit moyen de détection (13), pour se verrouiller lors de la réception dudit signal de déclenchement, et pour se déverrouiller lors de la réception dudit signal de remise à zéro, ledit verrouillage dudit second moyen de bascule (12B) étant indicatif de la détection d'une fuite du liquide ; et
un convertisseur de numérique en analogique programmé pour régler un seuil de sensibilité supérieur et un seuil de sensibilité inférieur desdits moyens de bascule (12A ; 12B), chacun défini par une certaine valeur de tension.

2. Circuit électrique selon la revendication 1, comprenant en outre :
un module de microrégisseur incluant :
1) un moyen pour faire que ledit moyen générateur d'impulsion électrique (10) produise ladite unique impulsion électrique d'envoi ;
2) un moyen (14) pour déterminer ledit seuil prédéterminé ; et
3) un moyen pour produire des premier et second signaux d'état de défaut en réponse à un état de verrouillage desdits premier et second moyens de bascule (12A ; 12B) respectifs, ledit signal d'état de défaut indiquant la fuite.

3. Circuit électrique selon la revendication 2, dans lequel :
ledit convertisseur de numérique en analogique reçoit lesdits seuils prédéterminés dudit module de microrégisseur, pour convertir chacun desdits seuils prédéterminés d'un signal numérique en un signal analogique, et pour délivrer ledit signal audit moyen de détection (13).

4. Circuit électrique selon la revendication 3, dans lequel ledit moyen de détection comprend :
un premier comparateur de tension (13), conçu pour produire un premier signal de déclenchement lorsque ladite impulsion d'envoi réfléchie dépasse un seuil positif, ledit premier signal de déclenchement étant indicatif d'une coupure dans ledit câble de détection de fuites ; et
un second comparateur de tension (13), conçu pour produire un second signal de déclenchement lorsque ladite impulsion d'envoi réfléchie dépasse un seuil négatif, ledit second signal de déclenchement étant indicatif d'une fuite du liquide.

5. Circuit électrique selon la revendication 4, dans lequel lesdits moyens de bascule comprennent :
une première bascule (12A) sensible audit premier signal de déclenchement ; et
une seconde bascule (12B) sensible audit second signal de déclenchement.

6. Procédé de surveillance de l'impédance d'un câble de détection de fuites refermé par une charge résistive adaptée, dans lequel un signal de défaut est produit en réponse à une variation de l'impédance du câble, le procédé comprenant les étapes :
(a) de sélection d'un seuil de détection de réflexion pour le câble de détection de fuites en utilisant un convertisseur de numérique en analogique ;
(b) de production d'une unique impulsion électrique d'envoi ;
(c) d'émission de ladite impulsion d'envoi dans le câble de détection de fuites (15) ;
(d) de prélèvement et de retardement d'une partie de ladite impulsion d'envoi pour produire un signal de remise à zéro ;
(e) de remise à zéro d'une bascule (12A ; 12B) en réponse audit signal de remise à zéro ;
(f) de surveillance du câble de détection de fuites (15) en ce qui concerne une impulsion d'envoi réfléchie ;
(g) de comparaison de ladite impulsion d'envoi réfléchie audit seuil de détection de réflexion ;
(h) de production d'un signal de déclenchement lorsque ladite impulsion d'envoi réfléchie dépasse ledit seuil de détection de réflexion ; et
(i) de mise à un de ladite bascule (12A ; 12B) et de production d'un signal de défaut en réponse audit signal de déclenchement.

7. Procédé selon la revendication 6, comprenant en outre une étape d'auto-étalonnage du câble de détection de fuites pour affiner ledit seuil de réflexion, ladite étape d'auto-étalonnage comprenant les étapes :
(1) de réglage dudit seuil de détection de réflexion à une valeur prédéterminée ;
(2) d'exécution des étapes (b) à (i) ;
(3) de surveillance de ladite bascule en ce qui concerne la production dudit signal de défaut ;
(4) si ledit signal de défaut n'est pas détecté, d'augmentation de la valeur dudit seuil de détection de réflexion d'une quantité prédéterminée, et de répétition des étapes (2) à (4) jusqu'à ce que ledit signal de défaut soit détecté ; et
(5) si ledit signal de défaut est détecté, de diminution de la valeur dudit seuil de détection de réflexion d'une quantité prédéterminée.
